(19) Europäisches Patentamt / European Patent Office / Office européen des brevets

(11) **EP 3 896 192 A1**

(12) **DEMANDE DE BREVET EUROPEEN**

(43) Date de publication:
20.10.2021 Bulletin 2021/42

(51) Int Cl.:
C23C 16/02 (2006.01)          C23C 16/455 (2006.01)
G04B 45/00 (2006.01)          G04D 3/00 (2006.01)

(21) Numéro de dépôt: 21167741.4

(22) Date de dépôt: 09.04.2021

(84) Etats contractants désignés:
AL AT BE BG CH CY CZ DE DK EE ES FI FR GB
GR HR HU IE IS IT LI LT LU LV MC MK MT NL NO
PL PT RO RS SE SI SK SM TR
Etats d'extension désignés:
BA ME
Etats de validation désignés:
KH MA MD TN

(30) Priorité: 16.04.2020 FR 2003856

(71) Demandeur: Richemont International S.A.
1752 Villars-sur-Glâne (CH)

(72) Inventeurs:
• GACHET, David
2000 Neuchâtel (CH)
• NOIRAUD, Guilhem
2300 La Chaux-de-Fonds (CH)
• TOBENAS, Susana
2555 Brügg (CH)

(74) Mandataire: LLR
11 boulevard de Sébastopol
75001 Paris (FR)

(54) **COMPOSANT HORLOGER AVEC UN SYSTÈME OPTIQUE INTERFÉRENTIEL AMÉLIORÉ COMPORTANT UNE COUCHE À BASE DE ZINC ET SON PROCÉDÉ DE FABRICATION**

(57) L'invention se rapporte à un composant horloger (1) formé d'un corps (10) à base d'un matériau à décorer qui est au moins partiellement recouvert d'au moins un système optique interférentiel (40), ce dernier comportant au moins une couche (30) de transmission formée à base d'un oxyde, d'un carbure, d'un sulfure ou d'un nitrure qui est obtenue par une méthode ALD afin d'au moins partiellement transmettre la lumière ambiante pour modifier l'aspect visuel du composant horloger (1). Selon l'invention, le système optique interférentiel (40) comporte en outre une couche (20) d'absorption à base de zinc montée sous la couche (30) de transmission sur le spectre visible humain permettant d'améliorer la précision des couleurs obtenues par le système optique interférentiel (40).

FIG. 4

EP 3 896 192 A1

## Description

DOMAINE TECHNIQUE DE L'INVENTION

L'invention concerne un composant muni d'un système optique interférentiel pour le décorer et notamment un tel système optique interférentiel permettant la modification au moins partielle de l'aspect visuel du composant à l'aide d'au moins une couche mince.

ARRIÈRE-PLAN TECHNIQUE DE L'INVENTION

Le document US 2013/029097 se propose d'offrir un aspect de porcelaine à un article métallique ou plastique. Il est prévu de déposer une couche d'accrochage sur l'article et, par-dessus, une couche transparente à base d'oxygène, d'azote et d'un matériau pouvant être en métal ou en non-métal afin de donner l'aspect vitreux de couleur blanche de la porcelaine. De manière optionnelle, afin d'éviter d'être marquée par des empreintes digitales, le tout peut être protégé par une couche d'oxyde d'aluminium ou d'oxyde de silicium. On comprend donc que seul l'aspect vitreux de couleur blanche de la porcelaine est recherché et qu'il est donné par la couche d'accrochage réfléchissant au travers de la couche transparente. De fait, aucun effet interférentiel ne peut être obtenu, c'est-à-dire une couleur précise ne peut pas être sélectivement choisie parmi plusieurs couleurs possibles pour obtenir une décoration prédéterminée. C'est d'autant plus vrai qu'il n'est prévu que des méthodes de dépôts physiques en phase vapeur (PVD) dont l'irrégularité d'épaisseur ne permet pas d'obtenir une couche optique prévisible et reproductible.

Il existe des traitements décoratifs de composants horlogers qui utilisent une étape de dépôt en couche atomique, généralement abrégé « méthode ALD » venant des termes anglais « Atomic Layer Déposition ». L'un des avantages de la méthode ALD, par rapport à d'autres méthodes de dépôt en couche mince telles que, par exemple, les dépôts physiques en phase vapeur réside dans l'uniformité de l'épaisseur de dépôt. De tels traitements décoratifs consistent à déposer une couche externe de protection en matériau céramique quasi-transparent. On peut citer le document CH 711 122 qui décrit un procédé de traitement décoratif selon lequel une première couche rugueuse et réfléchissante est déposée sur un substrat et une deuxième couche au moins partiellement transparente est déposée par une méthode ALD au-dessus de la première couche. Il est ainsi formé un revêtement protecteur et/ou décoratif de couleur blanche sur le substrat.

Bien que ces traitements décoratifs permettent d'obtenir des composants horlogers ayant des couleurs différentes, la variété de couleurs, qui est réalisable en variant la nature du matériau déposé et/ou l'épaisseur de la couche obtenue par la méthode ALD, est toujours insuffisante pour des applications décoratives exigeant des nuances de couleurs très spécifiques notamment si le substrat est en matériaux à base de cuivre très fréquemment utilisés pour les composants horlogers.

RÉSUMÉ DE L'INVENTION

L'invention a notamment pour but de proposer un composant horloger muni d'un système optique interférentiel capable de changer l'aspect visuel d'au moins une partie du composant permettant à ce dernier d'être sélectivement décoré selon au moins une nuance de couleur très précise parmi une grande variété de couleurs possibles.

À cet effet, l'invention se rapporte à un composant horloger formé d'un corps à base d'un matériau à décorer qui est au moins partiellement recouvert d'au moins un système optique interférentiel, ce dernier comportant au moins une couche de transmission formée à base d'un oxyde, d'un carbure, d'un sulfure ou d'un nitrure qui est obtenue par une méthode ALD afin d'au moins partiellement transmettre la lumière ambiante pour modifier l'aspect visuel du composant horloger, **caractérisé en ce que** le système optique interférentiel comporte en outre une couche d'absorption à base de zinc montée sous la couche de transmission permettant d'améliorer la précision des couleurs obtenues par le système optique interférentiel.

Avantageusement selon l'invention, le système optique interférentiel permet de changer l'aspect visuel d'au moins une partie du composant, c'est-à-dire suivant qu'il recouvre la totalité de la surface du composant ou seulement une partie, et selon au moins une nuance particulière, c'est-à-dire suivant que le composant comprend un (ou plusieurs) système(s) optique(s) interférentiel(s). Le composant, avantageusement selon l'invention, peut donc être sélectivement décoré selon au moins une nuance de couleur très précise parmi une grande variété de couleurs possibles et selon une très faible épaisseur afin de rendre possible la décoration de composant sans adaptation d'implantation particulière.

En outre, la couche d'absorption absorbe la lumière sur tout le spectre visible (pour la partie de la lumière transmise à l'interface couche de transmission - couche d'absorption) et joue aussi le rôle de couche semi-réfléchissante. C'est par phénomène d'interférence au travers des couches de transmission que la couleur est modulée à partir de la lumière partiellement réfléchie.

En effet, la combinaison de la couche d'absorption sous la couche (ou les couches) de transmission permet au système optique interférentiel d'offrir une nuance de couleur très précise parmi une grande variété de couleurs possibles. Plus précisément, le système optique interférentiel selon l'invention permet de sélectivement moduler l'intensité de lumière réfléchie pour offrir une haute visibilité d'interférence, ou haut contraste C (sans unité), c'est-à-dire au moins égale à 0,7, de manière préférée au moins égale à 0,75 et idéalement au plus proche de la valeur optimale de 1, de manière relativement constante sur tout le spectre visible humain.

Cela est rendu possible par l'utilisation de la couche d'absorption à base de zinc offrant un indice de réfraction complexe avec une partie réelle n et une partie imaginaire k (également appelée coefficient d'extinction) apte à former un coefficient de réflexion à l'interface entre la couche d'absorption et la couche de transmission proche de celui à l'interface entre de la couche de transmission et l'air entourant le composant horloger pour les matériaux formés à base d'un oxyde, d'un carbure, d'un sulfure ou d'un nitrure prévus pour le (ou les) couche(s) de transmission.

Enfin, avantageusement selon l'invention, il a été trouvé qu'une telle couche d'absorption à base de zinc peut offrir ces qualités de manière relativement constante sur tout le spectre visible humain ce qui permet de garder une précision de couleur sur un large domaine de longueurs d'onde pour la lumière incidente.

L'invention peut également comporter l'une ou plusieurs des caractéristiques optionnelles suivantes, prises seules ou en combinaison.

La couche d'absorption est préférentiellement un alliage comportant au moins 50 % de zinc en poids total de l'alliage afin d'optimiser le coefficient de réflexion de la lumière dans le spectre visible humain. La couche d'absorption peut ainsi être un alliage binaire comportant, outre le zinc, du nickel. On comprend que les alliages du type Zn-Ni ne sont que des exemples et ne sont pas les seuls permettant d'obtenir les avantages de l'invention.

Plus précisément, la couche d'absorption peut comprendre de 60 à 80 % de zinc en poids total de l'alliage et de 20 à 40 % restant en nickel. Selon un premier exemple, la couche d'absorption comprend sensiblement 80 % de zinc en poids total de l'alliage et 20 % restant en nickel. Selon un deuxième exemple, la couche d'absorption comprend sensiblement 70 % de zinc en poids total de l'alliage et 30 % restant en nickel.

La couche d'absorption présente préférentiellement une épaisseur au moins égale à 50 nm, et plus préférentiellement une épaisseur au moins égale à 100 nm, afin que l'onde électromagnétique associée à la lumière incidente ne puisse pas ou peu atteindre le composant en-dessous de la couche d'absorption. De manière générale, la lumière incidente est empêchée d'atteindre le composant ou est absorbée lorsqu'elle est réfléchie à l'interface entre le composant et la couche d'absorption. Il a été trouvé qu'une couche d'absorption d'une épaisseur de 200 nm donnait satisfaction.

Le système optique interférentiel peut comporter plusieurs couches de transmission empilées l'une sur l'autre par-dessus la couche d'absorption afin de pouvoir sélectionner une couleur précise. En effet, il est avantageusement possible par sélection de la nature et de l'épaisseur de ces empilements, de moduler l'intensité de lumière réfléchie afin de créer une nuance très précise de couleur sur le composant.

Au moins une première couche de transmission est empilée sur au moins une deuxième couche de transmission avec respectivement des indices de réfraction différents permettant de faire varier la couleur du composant en fonction des variations de nature, d'indice de réfraction et d'épaisseur de chaque couche de transmission. Il est ainsi préféré d'alterner une couche de transmission avec un indice de réfraction faible, c'est-à-dire par exemple compris entre 1,45 et 1,95 à une longueur d'onde de 620 nm, avec une autre couche de transmission d'indice de réfraction fort, c'est-à-dire par exemple compris entre 2,1 et 3,0 à une longueur d'onde de 620 nm, pour plus précisément moduler la lumière réfléchie et plus facilement ajuster la nuance de couleur souhaitée. Préférentiellement, le système optique interférentiel comporte un empilement de couches de transmission, c'est-à-dire sans l'épaisseur de la couche d'absorption, dont l'épaisseur totale est inférieure à 2 $\mu m$.

Le composant horloger peut former tout ou partie d'un habillage ou d'un mouvement horloger. À titre nullement limitatif, le matériau du corps à décorer peut ainsi être à base de métal, de verre, de silicium, de polymère ou d'une combinaison de ces matières.

L'invention se rapporte également à un procédé de fabrication d'un composant horloger tel que présenté plus haut, **caractérisé en ce que** le procédé comporte les étapes suivantes :

- former un corps ;
- déposer, sur au moins une partie du corps, une couche d'absorption à base de zinc ;
- déposer, par une méthode ALD, au moins une couche de transmission sur la couche d'absorption, chaque couche de transmission étant formée à base d'un oxyde, d'un carbure, d'un sulfure ou d'un nitrure afin de former un système optique interférentiel sur le corps.

Avantageusement selon l'invention, le procédé permet d'obtenir un système optique interférentiel permettant de changer l'aspect visuel d'au moins une partie du composant. Le composant peut donc être sélectivement décoré selon au moins une nuance de couleur très précise parmi une grande variété de couleurs possibles et selon une très faible épaisseur afin de rendre possible la décoration de composant sans adaptation d'implantation particulière.

En effet, la combinaison de la couche d'absorption sous la couche (ou les couches) de transmission permet au système optique interférentiel d'offrir une nuance de couleur très précise parmi une grande variété de couleurs possibles de manière relativement constante sur tout le spectre visible humain. Cela est rendu possible par l'utilisation de la couche d'absorption à base de zinc offrant un indice de réfraction complexe avec une partie réelle n et une partie imaginaire k (également appelée coefficient d'extinction) apte à former un coefficient de réflexion à l'interface entre la couche d'absorption et la couche de transmission proche de celui à l'interface entre de la couche de transmission et l'air entourant le composant horloger pour les matériaux formés à base d'un oxyde, d'un carbure, d'un sulfure ou d'un nitrure prévus pour le (ou les) couche(s) de transmission.

Enfin, avantageusement selon l'invention, la méthode ALD permet un dépôt en couche très mince et uniforme. Ainsi, l'uniformité de l'épaisseur de la (ou des) couche(s) de transmission apporte une qualité déterminante pour le système optique interférentiel notamment par la netteté des couleurs obtenues.

L'invention peut également comporter l'une ou plusieurs des caractéristiques optionnelles suivantes, prises seules ou en combinaison.

Le corps peut être formé à base de métal, de verre, de silicium, de polymère ou d'une combinaison de ces matières. On comprend en effet que, grâce à l'invention, le type de matériau du corps n'est plus un frein à la couleur souhaitée pour la décoration du composant horloger

Le procédé peut comporter, entre l'étape de formation du corps et l'étape de dépôt de la couche d'absorption, une étape de dépôt d'au moins une couche d'adhérence pour faciliter le montage du système optique interférentiel sur le corps. En effet, suivant les matériaux utilisés pour le corps, il peut être difficile de déposer la couche d'absorption à base de zinc.

L'étape de dépôt de la couche d'absorption peut être réalisée par électrodéposition, par un procédé de dépôt autocatalytique, par un procédé de dépôt physique en phase vapeur ou par un procédé de dépôt chimique en phase vapeur.

L'étape de dépôt, par la méthode ALD, peut former au moins une première couche de transmission empilée sur au moins une deuxième couche de transmission avec respectivement des indices de réfraction différents permettant de faire varier la couleur du composant horloger.

BRÈVE DESCRIPTION DES DESSINS

D'autres particularités et avantages de l'invention ressortiront clairement de la description qui en est faite ci-après, à titre indicatif et nullement limitatif, en référence aux dessins annexés, dans lesquels :

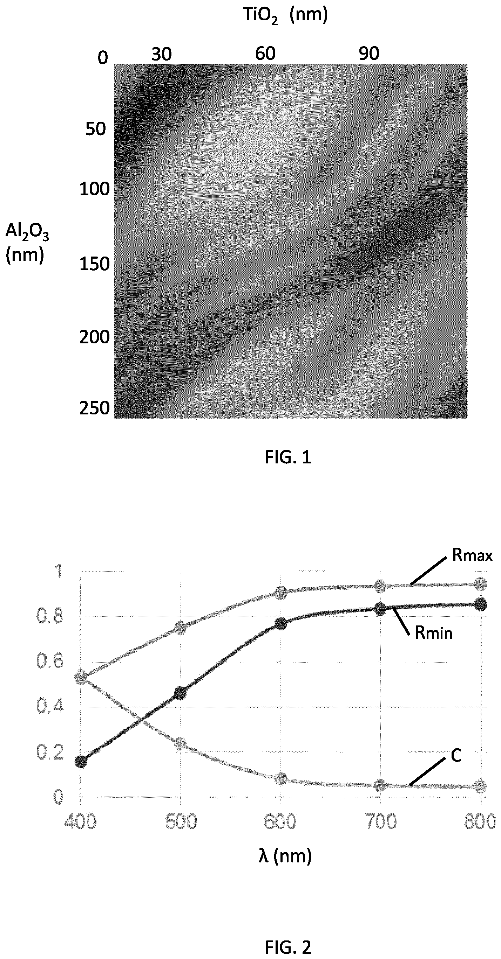

- la figure 1 est une représentation graphique des variations d'une nuance de couleur en fonction des variations d'épaisseur de deux couches de transmission selon l'invention ;
- la figure 2 est un diagramme de l'évolution des coefficients de réflexion minimal et maximal et du contraste C en fonction de la longueur d'onde d'un composant en laiton recouvert d'une unique couche d'alumine ($Al_2O_3$) ;

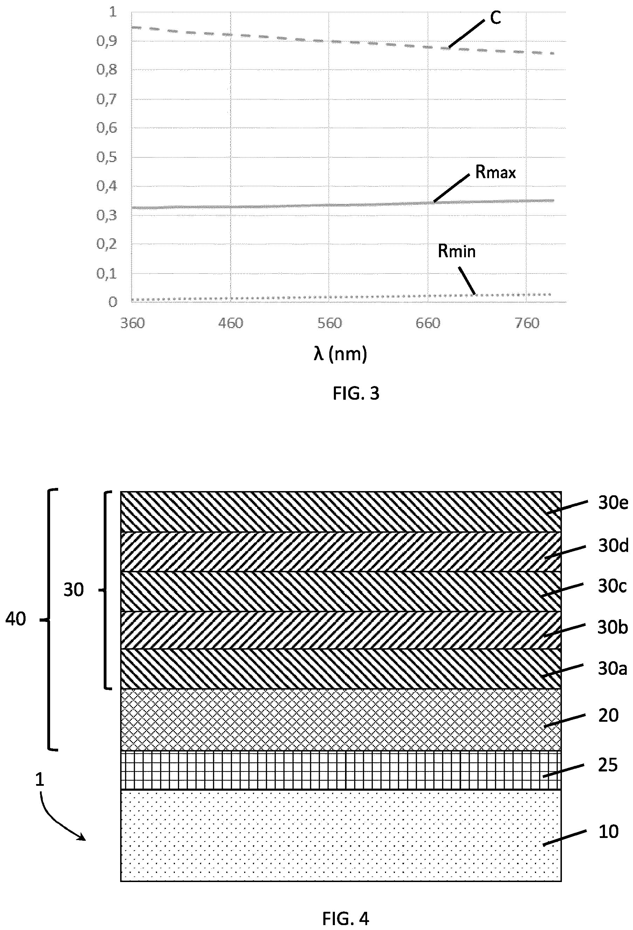

- la figure 3 est un diagramme de l'évolution des coefficients de réflexion minimal et maximal et du contraste C en fonction de la longueur d'onde d'un composant en laiton recouvert d'un système optique interférentiel selon l'invention ;
- la figure 4 est une représentation schématique d'un composant recouvert d'un exemple de système optique interférentiel selon l'invention ;

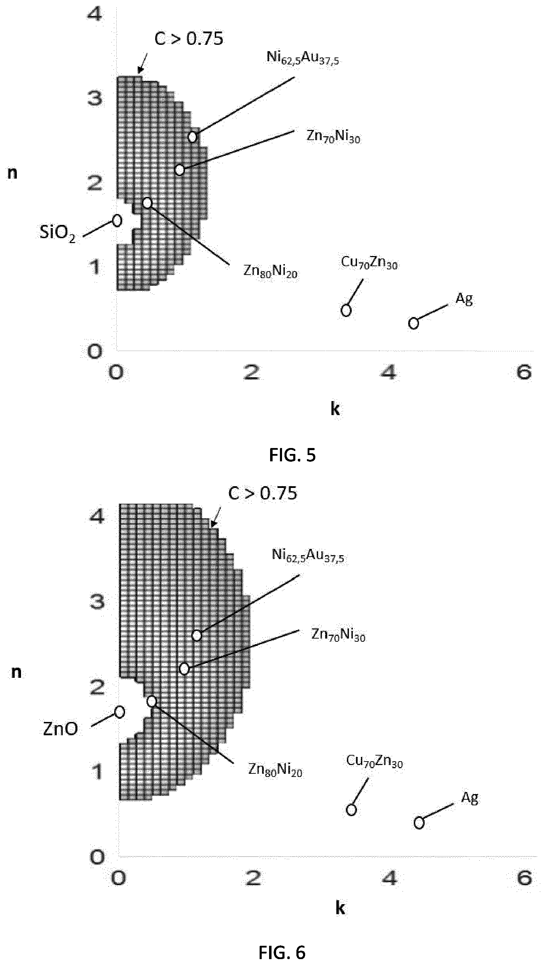

- la figure 5 est un diagramme illustrant une zone de haut contraste (C supérieur à 0,75) souhaitée par l'invention dont le système optique interférentiel comporte une couche de transmission unique d'oxyde de silicium ($SiO_2$) par rapport aux parties réelles et imaginaires de l'indice de réfraction de différents matériaux de couche d'absorption ;
- la figure 6 est un diagramme illustrant une zone de haut contraste (C supérieur à 0,75) souhaitée par l'invention dont le système optique interférentiel comporte une couche de transmission unique d'oxyde de zinc (ZnO) par rapport aux parties réelles et imaginaires de l'indice de réfraction de différents matériaux de couche d'absorption ;

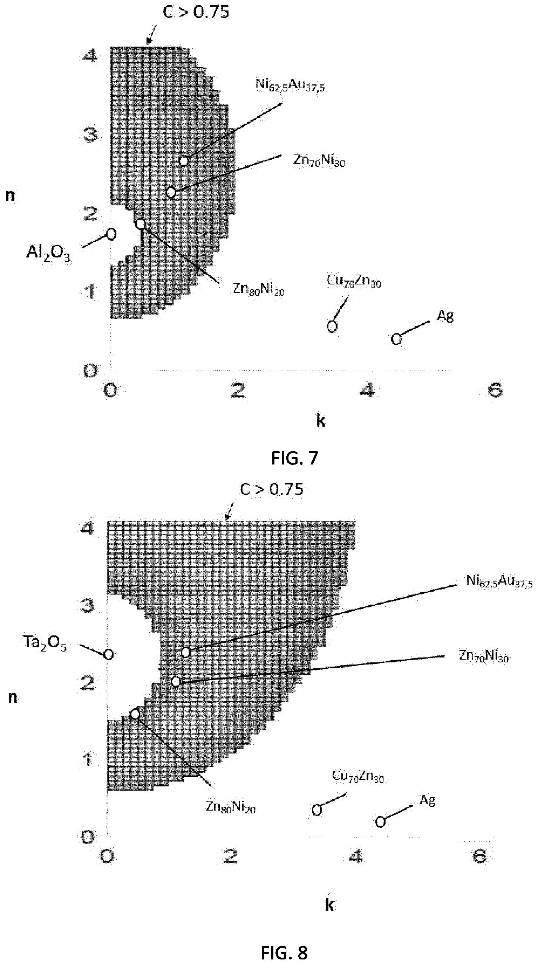

- la figure 7 est un diagramme illustrant une zone de haut contraste (C supérieur à 0,75) souhaitée par l'invention dont le système optique interférentiel comporte une couche de transmission unique d'alumine ($Al_2O_3$) par rapport aux parties réelles et imaginaires de l'indice de réfraction de différents matériaux de couche d'absorption ;
- la figure 8 est un diagramme illustrant une zone de haut contraste (C supérieur à 0,75) souhaitée par l'invention dont le système optique interférentiel comporte une couche de transmission unique d'oxyde de tantale ($Ta_2O_5$) par rapport aux parties réelles et imaginaires de l'indice de réfraction de différents matériaux de couche d'absorption ;

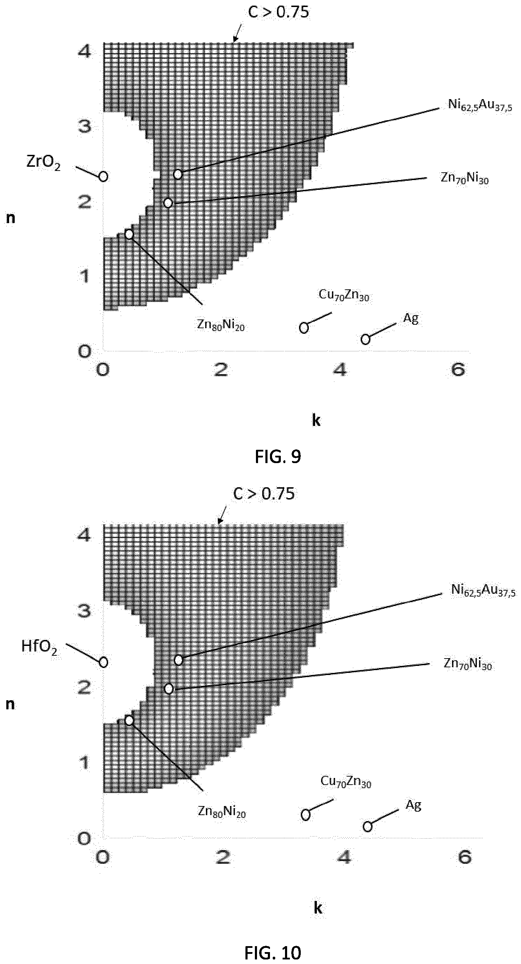

- la figure 9 est un diagramme illustrant une zone de haut contraste (C supérieur à 0,75) souhaitée par l'invention dont le système optique interférentiel comporte une couche de transmission unique de zircone ($ZrO_2$) par rapport aux parties réelles et imaginaires de l'indice de réfraction de différents matériaux de couche d'absorption ;
- la figure 10 est un diagramme illustrant une zone de haut contraste (C supérieur à 0,75) souhaitée par l'invention dont le système optique interférentiel comporte une couche de transmission unique d'oxyde d'hafnium ($HfO_2$) par rapport aux parties réelles et imaginaires de l'indice de réfraction de différents matériaux de couche d'absorption ;

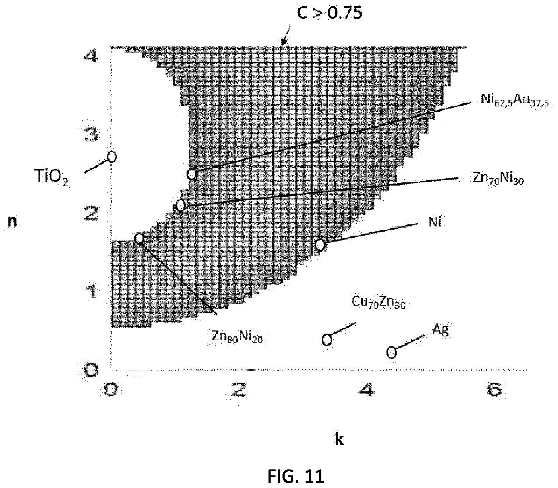

- la figure 11 est un diagramme illustrant une zone de haut contraste (C supérieur à 0,75) souhaitée par l'invention dont le système optique interférentiel comporte une couche de transmission unique d'oxyde de titane ($TiO_2$) par rapport aux parties réelles et imaginaires de l'indice de réfraction de différents matériaux de couche d'absorption.

DESCRIPTION DÉTAILLÉE D'AU MOINS UN MODE DE RÉALISATION DE L'INVENTION

Sur les différentes figures, les éléments identiques ou similaires portent les mêmes références, éventuellement additionnés d'un indice. La description de leur structure et de leur fonction n'est donc pas systématiquement reprise.

Dans tout ce qui suit, les orientations sont les orientations des figures. En particulier, les termes « supérieur », « inférieur », « gauche », « droit », « au-dessus », « en-dessous », « vers l'avant » et « vers l'arrière » s'entendent généralement par rapport au sens de représentation des figures.

Par « spectre visible humain », on entend le domaine de longueurs d'onde compris entre 380 et 780 nm au sens de la norme ISO/CIE 11664-3:2019 de la Commission internationale de l'éclairage « CIE ».

Par « pièce d'horlogerie », on entend tous les types d'instruments de mesure ou de comptage du temps tels que les pendules, les pendulettes, les montres, etc...

Par « mouvement horloger », on entend tous les types de mécanisme capables de compter le temps qu'ils soient alimentés à base d'énergie mécanique (par exemple un barillet) ou électrique (par exemple une batterie).

Par « habillage », on entend tous les types de dispositifs capables de contenir, afficher, décorer et/ou commander un mouvement horloger comme, par exemple, tout ou partie d'une boîte, d'un bracelet ou d'un affichage.

Par « à base de », on entend un matériau ou alliage ayant sensiblement au moins 50 % en masse totale ou poids d'un élément donné.

Dans ce qui suit, sauf indication contraire, tous les pourcentages (%) indiqués sont des pourcentages en masse totale ou poids (en anglais « weight »).

L'invention se rapporte généralement à un composant 1 formé d'un corps 10 à base d'un matériau à décorer. Selon l'invention, le corps 10 du composant 1 est, avantageusement, au moins partiellement recouvert d'au moins un système optique interférentiel 40 afin de changer l'aspect visuel de la partie du corps 10 sur lequel est monté le système optique interférentiel 40. En effet, le système optique interférentiel 40 peut recouvrir la totalité de la surface externe du corps 10 ou seulement une partie, comme une face ou une partie d'une face.

De plus, avantageusement selon l'invention, le composant 1 peut être décoré selon au moins une nuance de couleur particulière suivant qu'il comprenne un ou plusieurs système(s) optique interférentiel(s) 40. En effet, comme mieux expliqué ci-dessous, chaque système optique interférentiel 40 permet au composant 1 de pouvoir être sélectivement décoré selon au moins une nuance de couleur très précise parmi une grande variété de couleurs possibles et selon une très faible épaisseur. On comprend qu'il est donc possible de rendre la décoration de composant 1 sans adaptation d'implantation particulière de ce dernier.

Le composant 1 a été développé pour s'appliquer au domaine horloger. Ainsi, le composant peut former tout ou partie d'un habillage horloger comme tout ou partie d'un cadran, d'un affichage tel qu'une aiguille ou un disque, d'une boîte, d'un bracelet, d'une glace ou d'un organe de commande tel qu'une couronne ou un bouton-poussoir. Le composant 1 peut également former tout ou partie d'un mouvement comme tout ou partie d'un dispositif d'échappement tel qu'un mécanisme à ancre suisse, d'un résonateur tel qu'un mécanisme balancier - spiral, d'une source d'énergie tel qu'un barillet, un système de remontage automatique ou une batterie, d'un rouage tel qu'un mobile ou une roue dentée, d'un ressort, d'une vis, d'un pont ou d'une platine. À titre nullement limitatif, le matériau du corps 10 à décorer peut ainsi être à base de métal, de verre, de silicium, de polymère, ou d'une combinaison de ces matières. À titre d'exemple, le composant 1 peut être un cadran dont le corps 10 est en laiton ou en fer doux. Selon un autre exemple, le composant 1 peut-être une aiguille dont le corps 10 est en alliage à base de titane.

Bien entendu, l'invention ne saurait se limiter au domaine horloger. Ainsi, l'invention pourrait également être appliquée dans d'autres domaines tels que, par exemple, la bijouterie, la joaillerie, la maroquinerie, les arts de la table, les instruments d'optique ou les instruments d'écriture.

Le système optique interférentiel 40 comporte au moins une couche 30 de transmission recouvrant au moins une partie du composant 1 afin d'au moins partiellement transmettre la lumière ambiante pour modifier l'aspect visuel du composant 1. Chaque couche 30 de transmission peut être obtenue à partir d'un dépôt physique en phase vapeur ou un dépôt chimique en phase vapeur afin de préférentiellement déposer une épaisseur comprise entre 1 et 100 nm. Toutefois, le dépôt chimique en phase vapeur est préféré et, plus précisément, une méthode ALD pour sa capacité à déposer de manière précise de fines couches de matériau.

En effet, la méthode ALD est un procédé de dépôt de couches atomiques permettant donc un dépôt en couche très mince et uniforme, c'est-à-dire typiquement à ± 1 nm. En effet, plus que la valeur de l'épaisseur, c'est l'uniformité de l'épaisseur de la (ou des) couche(s) 30 de transmission qui est particulièrement déterminante pour la qualité du système optique interférentiel 40 notamment par la netteté des couleurs obtenues. La méthode ALD consiste à exposer une surface successivement à différents précurseurs chimiques afin d'obtenir des couches ultra-minces de composés métalliques, oxydes ou autres matériaux. Elle est basée sur des réactions de surface auto-saturées qui ont lieu séquentiellement permettant une croissance contrôlée. En général, un cycle d'une méthode ALD comprend au moins deux injections de précurseurs, ces injections étant séparées par une étape de purge servant à éliminer le précurseur et les produits de réaction superflus avant l'introduction de l'autre précurseur. Avantageusement, la technologie ALD permet de déposer des couches sur une surface présentant un très fort rapport d'aspect, car la réaction se déroule sur une monocouche de gaz précurseurs adsorbés directement à la surface. La méthode ALD étant très connue, elle ne sera pas d'avantage expliquée ci-dessous.

Selon l'invention, chaque couche 30 de transmission comprend préférentiellement un matériau céramique que la très faible épaisseur rend quasi-transparent au spectre visible humain. Les céramiques, déposées sous forme cristalline et/ou amorphe, peuvent notamment comprendre des oxydes notamment métalliques tels que l'oxyde d'aluminium (alumine, $Al_2O_3$), l'oxyde de zinc (ZnO), l'oxyde de titane ($TiO_2$), l'oxyde de silicium ($SiO_2$), l'oxyde de zirconium (zircone, $ZrO_2$), l'oxyde de tantale ($Ta_2O_5$) et l'oxyde d'hafnium ($HfO_2$). Chaque couche 30 de transmission peut également être formée à base d'un carbure par exemple métallique, d'un sulfure par exemple métallique ou d'un nitrure par exemple métallique sans sortir du cadre de l'invention.

Les inventeurs se sont aperçus qu'au moins une couche 30 de transmission appliquée directement sur la surface d'un composant 1 résulte en un système optique interférentiel 40 limité quant à la diversité possible des nuances de couleurs. Ceci est notamment le cas, par exemple, pour des laitons et les autres alliages à base de cuivre qui sont largement utilisés dans la fabrication de composants horlogers.

Pour remédier cet inconvénient, les inventeurs ont découvert qu'il était nécessaire que la visibilité d'interférence, également appelée le contraste interférentiel ou simplement contraste C, au travers du système optique interférentiel 40 qui est déposé sur le corps 10 du composant 1 doit avoir une valeur élevée, c'est-à-dire le plus proche possible à sa valeur optimale de 1.

La valeur du contraste C est notamment une fonction de la réflexion de la lumière incidente, pour une longueur d'onde donnée, aux différentes interfaces du système optique interférentiel 40. En prenant le cas d'une couche 30 de transmission unique appliquée sur le corps 10, le contraste C est donné par :

$$C = \frac{R_{max} - R_{min}}{R_{max} + R_{min}}$$

où les coefficients de réflexion minimale $R_{min}$ et de réflexion maximale $R_{max}$ sont donnés par :

$$R_{min} = \left(\frac{\sqrt{R_1} - \sqrt{R_2}}{1 - \sqrt{R_1 R_2}}\right)^2$$

$$R_{max} = \left(\frac{\sqrt{R_1} + \sqrt{R_2}}{1 + \sqrt{R_1 R_2}}\right)^2$$

Dans ce cas, $R_1$ est le coefficient de réflexion à l'interface air - couche 30 de transmission et $R_2$ est le coefficient de réflexion à l'interface couche 30 de transmission - corps 10. Les valeurs des coefficients $R_1$, $R_2$

dépendent des indices de réfraction de la couche 30 de transmission et du corps 10. L'indice de réfraction de l'air est supposé spectralement uniforme et égal à 1. L'indice de réfraction est une grandeur sans dimension caractéristique d'un milieu qui décrit le comportement de la lumière dans celui-ci et dépend de la longueur d'onde de mesure. Dans un milieu absorbant, l'indice de réfraction complexe ñ est un nombre complexe dont la partie imaginaire rend compte de l'atténuation de l'onde selon la relation suivante :

$$\tilde{n} = n + ik$$

n étant la partie réelle de l'indice de réfraction du milieu et k la partie imaginaire de l'indice de réfraction du milieu (aussi appelée coefficient d'extinction), c'est-à-dire la capacité d'absorption du milieu.

Si on suppose que la couche 30 de transmission est non-absorbante (k = 0), les coefficients de réflexion aux interfaces, $R_1$ et $R_2$, pour une onde lumineuse monochromatique sous incidence normale, se calculent de la manière suivante :

$$R_1 = \left(\frac{n_0 - 1}{n_0 + 1}\right)^2$$

$$R_2 = \frac{(n_1 - n_0)^2 + k_1^2}{(n_1 + n_0)^2 + k_1^2}$$

où $n_0$ est l'indice de réfraction de la couche 30 de transmission, $n_1$ est la partie réelle de l'indice de réfraction du corps 10, et $k_1$ est le coefficient d'extinction, parfois appelé coefficient d'absorption, du corps 10, pour la longueur d'onde de l'onde incidente.

La figure 2 présente un exemple de ce que l'invention souhaite éviter. La figure 2 montre l'évolution du contraste C pour une monocouche d'alumine ($Al_2O_3$) déposée par une méthode ALD directement sur un corps 10 en laiton pour les différentes longueurs d'onde du spectre visible humain. Les coefficients $R_{max}$ et $R_{min}$ se rapprochent l'un de l'autre, et, par conséquent, le contraste C reste bien inférieur à 1, et notamment en général inférieur à 0,5, dans le spectre visible humain. On peut voir que le contraste C tend même vers 0 pour les couleurs plus rouges. Il ressort de cette limitation que les couleurs réalisables par une telle couche 30 de transmission à base d'alumine sur un corps 10 en laiton sont principalement des nuances de jaune et ceci avec une luminance très élevée.

Les inventeurs ont pu découvrir, au vu des relations citées ci-dessus, que cette limitation chromatique de l'exemple de la figure 2 est due au fait que les coefficients $R_1$ et $R_2$ de réflexion aux deux interfaces sont très différents, ce qui résulte en un système optique interférentiel 40 dans lequel les coefficients $R_{max}$ et $R_{min}$ sont relativement proches. Le contraste C est, par conséquent, relativement bas ce qui limite les couleurs possibles d'être obtenues.

De manière générale, dans le spectre visible humain, les coefficients R de réflexion aux interfaces dans un tel système optique interférentiel 40 comprenant les couches 30 de transmission mentionnées ci-dessus sont relativement bas, typiquement inférieurs à 20 %. À titre d'exemple, pour une longueur d'onde de 550 nm, le coefficient de réflexion à une interface air - $TiO_2$ est environ 18 %, environ 6 % à une interface air - $Al_2O_3$ et environ 4 % à une interface $TiO_2$ - $Al_2O_3$.

Plus précisément, il ressort de ce qui précède que pour obtenir un système optique interférentiel 40 avec un haut contraste interférentiel C capable de donner une profondeur de couleur attrayante, le coefficient de réflexion $R_2$ à l'interface entre la (ou les) couche(s) 30 de transmission et le corps 10 du composant 1 doit lui aussi être similairement relativement faible, ce qui peut notamment être le cas si les indices de réfaction $n_0$ et $n_1$ sont proches et que la valeur de $k_1$ est relativement faible.

Pour réduire la luminance et ainsi de rendre accessible plus de couleurs au système optique interférentiel 40 sans être dépendant du matériau du corps 10, le système optique interférentiel 40 selon l'invention comporte, sous la (ou les) couche(s) 30 de transmission, une couche 20 d'absorption dont les coefficients de son indice de réfraction complexe permettent au système optique interférentiel 40 d'obtenir un haut contraste interférentiel C sur le spectre visible humain. Plus précisément, il est recherché que la couche 20 d'absorption forme un coefficient $R_2$ de réflexion à l'interface entre la couche 20 d'absorption et la couche 30 de transmission le plus proche possible de celui $R_1$ à l'interface entre de la couche 30 de transmission et l'air entourant le composant horloger 1 sur le spectre visible humain.

Ainsi, il a pu être observé qu'en ayant une différence ($R_2$ - $R_1$) entre les coefficients $R_2$ et $R_1$ dans une plage d'environ ± 16 % dans le spectre visible humain, le contraste C présente typiquement une valeur préférée de haut contraste, c'est-à-dire au moins égale à 0,7. Par exemple, le coefficient $R_1$ de réflexion à une interface air - $TiO_2$ évoluant entre environ 27 % et 17 % sur le spectre visible humain en ayant une valeur d'environ 18 % à la longueur d'onde de 550 nm, le coefficient $R_2$ de réflexion à une interface $TiO_2$ - couche 20 d'absorption devrait préférentiellement évoluer entre environ 43 % - 11 % et 33 % - 1 % sur le spectre visible humain. Bien entendu, la valeur $R_2$ de réflexion quand elle atteint 1,2 % est à une limite en-dessous de laquelle il devient difficile de trouver un matériau pouvant satisfaire cette caractéristique. Ainsi, quand on prend le cas du coefficient $R_1$ de réflexion à une interface air - $Al_2O_3$ évoluant entre environ 6,5 % et 5,5 % sur le spectre visible humain, on comprend qu'il sera plus fréquent de trouver des matériaux permettant d'obtenir un coefficient $R_2$ de réflexion à l'interface

supérieur à celui $R_1$ de l'interface air - $Al_2O_3$.

La couche 20 d'absorption n'a donc pas pour but de réfléchir le maximum de lumière transmise par la (ou les) couche(s) 30 de transmission mais d'adapter la réflexion de cette lumière transmise afin de limiter la luminance, c'est-à-dire sélectivement absorber et réfléchir la lumière incidente dans le système optique interférentiel 40 pour permettre l'obtention d'une grande diversité de couleurs par la nature et l'épaisseur de chaque couche 30 de transmission déposée contre la couche 20 d'absorption. On peut par conséquent obtenir des couleurs ayant des paramètres d'espace colorimétrique, comme par exemple CIELAB, avec des valeurs plus précises afin que l'écart entre la cible désirée et la couleur obtenue soit minimisé et reproductible.

Avantageusement selon l'invention, le système optique interférentiel 40 permet ainsi de changer l'aspect visuel d'un composant, c'est-à-dire notamment sa couleur. En effet, la combinaison de la couche 20 d'absorption sous la couche 30 de transmission permet au système optique interférentiel 40 d'offrir une nuance de couleur très précise parmi une grande variété de couleurs possibles. Plus précisément, le système optique interférentiel 40 selon l'invention permet de sélectivement moduler l'intensité de lumière réfléchie pour offrir, de manière relativement constante sur tout le spectre visible humain, une haute visibilité d'interférence, ou haut contraste interférentiel C, c'est-à-dire au moins égale à 0,7, de manière préférée au moins égale à 0,75 et idéalement au plus proche de la valeur optimale de 1.

La couche 20 d'absorption comporte préférentiellement une épaisseur au moins égale à 50 nm, et plus préférentiellement une épaisseur au moins égale à 100 nm, afin que l'onde électromagnétique associée à la lumière incidente ne puisse pas ou peu atteindre le corps 10 du composant 1 en-dessous de la couche 20 d'absorption. La couche 20 d'absorption peut ainsi présenter une épaisseur égale à 50 nm, 60 nm, 70 nm, 80 nm, 90 nm, 100 nm, 110 nm, 120 nm, 130 nm, 140 nm, 150 nm, 160 nm, 170 nm, 180 nm, 190 nm, 200 nm, 225 nm ou 250 nm. De manière générale, la lumière incidente est empêchée d'atteindre le corps 10 du composant 1 ou est absorbée lorsqu'elle est réfléchie à l'interface entre le corps 10 du composant 1 et la couche 20 d'absorption. Il a été trouvé qu'une couche 20 d'absorption d'une épaisseur de 200 nm donnait satisfaction. Cette couche 20 d'absorption peut être déposée par différents moyens, mais de préférence elle est formée par électrodéposition telle qu'une galvanoplastie. La couche 20 d'absorption peut également être déposée par un procédé de dépôt autocatalytique ou un procédé de dépôt physique ou chimique en phase vapeur.

Selon l'exemple particulier d'une couche 30 de transmission en céramique expliquée ci-dessous comme, par exemple, à base d'un oxyde préférentiellement métallique, d'un carbure préférentiellement métallique, d'un sulfure préférentiellement métallique ou d'un nitrure préférentiellement métallique, les inventeurs ont trouvé qu'une couche 20 d'absorption à base de nickel ou à base de zinc donnait pleinement satisfaction notamment parce que ces couches avaient des indices de réfraction complexes permettant à obtenir un haut contraste C.

Pour illustrer cela, les figures 5 à 11 indiquent, chacune pour un type de matériau de couche 30 de transmission unique, la localisation de différents matériaux de couche 20 d'absorption par rapport à une zone de haut contraste C privilégiée. La figure 5 illustre une zone de haut contraste C pour un système optique interférentiel 40 avec une couche 30 de transmission unique d'oxyde de silicium ($SiO_2$) par rapport aux parties réelles et imaginaires de l'indice de réfraction de différents matériaux de couche 20 d'absorption. La figure 6 illustre une zone de haut contraste C pour un système optique interférentiel 40 avec une couche 30 de transmission unique d'oxyde de zinc (ZnO) par rapport aux parties réelles et imaginaires de l'indice de réfraction de différents matériaux de couche 20 d'absorption. La figure 7 illustre une zone de haut contraste C pour un système optique interférentiel 40 avec une couche 30 de transmission unique d'alumine ($Al_2O_3$) par rapport aux parties réelles et imaginaires de l'indice de réfraction de différents matériaux de couche 20 d'absorption. La figure 8 illustre une zone de haut contraste C pour un système optique interférentiel 40 avec une couche 30 de transmission unique d'oxyde de tantale ($Ta_2O_5$) par rapport aux parties réelles et imaginaires de l'indice de réfraction de différents matériaux de couche 20 d'absorption. La figure 9 illustre une zone de haut contraste C pour un système optique interférentiel 40 avec une couche 30 de transmission unique de zircone ($ZrO_2$) par rapport aux parties réelles et imaginaires de l'indice de réfraction de différents matériaux de couche 20 d'absorption. La figure 10 illustre une zone de haut contraste C pour un système optique interférentiel 40 avec une couche 30 de transmission unique d'oxyde d'hafnium ($HfO_2$) par rapport aux parties réelles et imaginaires de l'indice de réfraction de différents matériaux de couche 20 d'absorption. La figure 11 illustre une zone de haut contraste C pour un système optique interférentiel 40 avec une couche 30 de transmission unique d'oxyde de titane ($TiO_2$) par rapport aux parties réelles et imaginaires de l'indice de réfraction de différents matériaux de couche 20 d'absorption.

Dans ces exemples, la zone de haut contraste C représente une zone dans laquelle le contraste moyen C sur le spectre visible humain est au moins égal approximativement à 0,75, le contraste étant plus élevé au centre de la zone qu'à ses frontières. Pour plus de simplicité, pour calculer le contraste C moyen dans ces figures 5 à 11, on suppose que la couche 20 d'absorption présente un indice de réfraction complexe (n, k) constant sur la plage spectrale entre 340 et 780 nm, on calcule le contraste C pour chaque longueur d'onde comprise sur la plage spectrale 340-780 nm, et on fait la moyenne du contraste C sur la plage spectrale 340-780 nm. Les valeurs des indices de réfraction des substrats indiquées sur les figures 5 à 11 sont prises à 550 nm, ce qui est situé au milieu de la plage spectrale 340-780 nm.

On remarque que pour ces types de couches de transmission ayant des indices de réfraction assez différents, plusieurs alliages à base de nickel et à base de zinc permettent d'obtenir un système optique interférentiel 40 ayant un haut contraste C, contrairement, par exemple, à une couche formée d'un alliage de laiton (70 % de cuivre) ou d'argent. Ainsi, pour ces matériaux céramiques de couche 30 de transmission, une couche 20 d'absorption à base de nickel ou de zinc offre un coefficient $R_2$ de réflexion à l'interface entre la couche 20 d'absorption et la couche 30 de transmission proche de celui $R_1$ à l'interface entre de la couche 30 de transmission et l'air entourant le composant horloger 1 sur le spectre visible humain.

Le nickel (Ni) appartient au groupe d'éléments, dits métaux de transition, du tableau périodique des éléments, également appelé tableau de Mendeleïev, qui possède des bonnes propriétés d'absorption de la lumière étant donné qu'il peut former des ions stables avec des orbitales atomiques « d » qui ne sont remplies que partiellement. De plus, en forme pure c'est-à-dire comportant au moins 95 % de nickel, le nickel a une couleur blanc argent qui reste neutre quant à la colorimétrie.

De manière similaire, le zinc (Zn), en forme pure c'est-à-dire comportant au moins 95 % de zinc, le zinc a une couleur gris clair qui reste neutre quant à la colorimétrie.

Bien entendu, suivant le type de matière utilisé pour la couche 30 de transmission, une couche 20 d'absorption peut être à base d'un matériau différent du nickel ou du zinc afin, selon l'invention, d'offrir un coefficient $R_2$ de réflexion à l'interface entre la couche 20 d'absorption et la couche 30 de transmission proche de celui $R_1$ à l'interface entre de la couche 30 de transmission et l'air entourant le composant horloger 1 sur le spectre visible humain.

Comme expliqué ci-dessus, le système optique interférentiel 40 peut comporter plusieurs couches 30 de transmission empilées l'une sur l'autre par-dessus la couche 20 d'absorption afin de pouvoir sélectionner une couleur précise. En effet, il est avantageusement possible, par sélection de la nature et de l'épaisseur de chaque couche 30 de cet empilement, de moduler l'intensité de lumière réfléchie afin de créer une nuance très précise de couleur sur le composant 1.

Selon une première variante, le système optique interférentiel 40 comprend au moins une couche 30 de transmission en oxyde d'aluminium ($Al_2O_3$). Selon une deuxième variante, le système optique interférentiel 40 comprend au moins une couche 30 de transmission en dioxyde de titane ($TiO_2$). Dans une troisième variante préférée, le système optique interférentiel 40 comprend au moins une couche 30 de transmission en oxyde d'aluminium ($Al_2O_3$) et au moins une couche 30 de transmission en dioxyde de titane ($TiO_2$).

Plus généralement, comme visible dans l'exemple de la figure 4, préférentiellement selon l'invention, au moins une première couche 30, 30a, 30c, 30e de transmission est empilée sur au moins une deuxième couche 30, 30b, 30d de transmission avec respectivement des indices de réfraction différents permettant de faire varier la couleur du composant en fonction des variations de nature, d'indice de réfraction et d'épaisseur de chaque couche 30 de transmission. Il est ainsi préféré d'alterner une couche 30, 30a, 30c, 30e de transmission avec un indice de réfraction faible, c'est-à-dire par exemple compris entre 1,45 et 1,95 à une longueur d'onde de 620 nm, avec une autre couche 30, 30b, 30d de transmission d'indice de réfraction fort, c'est-à-dire par exemple compris entre 2,1 et 3,0 à une longueur d'onde de 620 nm, pour plus précisément moduler la lumière réfléchie et plus facilement ajuster la nuance de couleur souhaitée.

Préférentiellement, le système optique interférentiel 40 comporte un empilement de couches 30, 30a, 30b, 30c, 30d, 30e de transmission, c'est-à-dire sans l'épaisseur de la couche 20 d'absorption, dont l'épaisseur totale est inférieure à 2 $\mu$m. Lors des études réalisées, il est apparu que des couleurs satisfaisantes étaient obtenues pour un empilement de couches 30, 30a, 30b, 30c, 30d, 30e de transmission d'épaisseur totale inférieure à 300 nm.

Afin de pouvoir obtenir un bon pouvoir interférentiel dans un système optique interférentiel 40 avec plusieurs couches 30 de transmission, il faut adapter les conditions décrites (cf. les relations mathématiques ci-dessus) pour le système optique interférentiel 40 à une seule couche 30 de transmission, qui stipulent que les valeurs des coefficients de réflexion aux diverses interfaces doivent être les plus proches possibles les unes des autres.

Si l'on considère un système optique interférentiel 40 avec deux types de couches 30 de transmission seulement (de haut et bas indices de réfraction, respectivement $n_H$ et $n_B$), il faut adapter les équations des coefficients de réflexion aux interfaces, $R_1$ et $R_2$, aux différents cas (première couche 30 de transmission déposée sur la couche 20 d'absorption d'indice $n_B$ ou $n_H$, etc., dernière couche 30 de transmission au contact de l'air d'indice $n_B$ ou $n_H$). En particulier, il faut prendre en compte le coefficient de réflexion aux interfaces entre couches d'indices de réfraction haut et bas :

$$R = \frac{(n_B - n_H)^2 + k_B^2}{(n_B + n_H)^2 + k_B^2}$$

où $k_B$ est le coefficient d'extinction de la couche 30 de transmission à bas indice de réfraction qui peut être considéré comme négligeable (tout comme le coefficient d'extinction de la couche 30 de transmission à haut indice de réfraction).

L'indice globale de réfraction de l'empilement des couches 30 de transmission est de préférence compris entre 1,45 et 2,7 sur le spectre visible humain.

À titre d'exemple, une représentation graphique des variations d'une nuance de couleur en fonction des variations d'épaisseur de deux couches 30 de transmission selon l'invention est illustrée à la figure 1. Le système optique interférentiel 40 comporte, pour cet exemple, une couche 30 de transmission en d'oxyde d'aluminium ($Al_2O_3$) avec un indice de réfraction faible sur le spectre visible humain, c'est-à-dire compris entre 1,6 et 1,7, qui est déposée au-dessus d'une couche 30 de transmission d'oxyde de titane ($TiO_2$) avec un indice de réfraction fort sur le spectre visible humain, c'est-à-dire compris entre 2,1 et 3,0. On s'aperçoit immédiatement la grande variation de nuances obtenue malgré les faibles variations d'épaisseur de chacune des deux couches 30 de transmission.

Comme expliqué ci-dessus, la couche 20 d'absorption a pour but d'adapter le coefficient de réflexion à son interface avec la première des couches 30 de transmission aux coefficients de réflexion des autres interfaces du système optique interférentiel 40, voire dans cet exemple des interfaces entre une couche 30 de transmission « fort indice » avec un couche 30 de transmission « faible indice » ainsi que de l'interface de la dernière couche 30 de transmission avec l'air entourant le composant 1. À cet effet, le matériau de la couche 20 de transmission peut être modifié pour adapter les coefficients de son indice de réfraction complexe sans perdre d'autres de ses qualités. Dans l'exemple du nickel ou du zinc expliqué ci-dessus, la couche 20 d'absorption peut ainsi être un alliage comportant du nickel ou du zinc afin d'adapter ses coefficients d'indice de réflexion complexe tout en gardant une grande stabilité sur le spectre visible humain.

Les inventeurs ont par exemple trouvé qu'une couche 20 d'absorption à base d'alliage binaire comportant de l'or ou du zinc en complément du nickel ou du nickel en complément du zinc donnait satisfaction. Bien entendu, on comprend que les alliages du type Ni-Au ou Ni-Zn, ou du type Zn-Ni ne sont que des exemples et ne sont pas les seuls permettant d'obtenir les avantages de l'invention. Il est bien entendu possible d'envisager d'autres alliages que ceux binaires et, notamment, qui pourrait comprendre plus d'éléments que deux métaux en dehors des composés habituels dits de pollution dont la proportion en poids ne dépasse pas 0,2 % de la masse totale de l'alliage.

À titre d'exemple, l'alliage binaire Zn-Ni peut être déposée par galvanoplastie en utilisant un bain d'électrolyte dont la base est constituée principalement de sulfate de nickel hexahydraté 10 - 25 %, de chlorure de nickel hexahydraté 2,5 - 10 %, de sulfate de zinc (mono-, hexa- et heptahydraté) 2,5 - 10 %, de thiocyanate de sodium ≤ 2,5 % et un pH électrométrique (à 20 °C) de 5,8 à 6. La température de dépôt peut être réglée dans une fenêtre entre 22 °C et 17 °C. De préférence, elle est régulée le long du dépôt à 18 °C et la densité de courant de 0,12 à 0,15 A.dm$^{-2}$.

L'alliage binaire obtenu comprend, par exemple de 60 à 80 % de zinc en poids total de l'alliage et de 20 à 40 % restant en nickel. Dans un exemple spécifique, l'alliage comprend sensiblement 80 % de zinc et 20 % restant en nickel et a une couleur gris foncé. La figure 3 montre l'évolution du contraste C pour une monocouche d'alumine ($Al_2O_3$) déposée sur une couche 20 d'absorption en un tel alliage de zinc-nickel. Il ressort de la figure 3 que la valeur du contraste C reste avantageusement supérieure à 0,8 sur l'ensemble du spectre visible humain.

Comme les figures 5 à 11 le montrent, l'alliage de sensiblement 80 % de zinc et 20 % en nickel présente un indice de réfraction complexe à une longueur d'onde de 550 nm avec n ≈ 1,8 et k ≈ 0,32. Dans un autre exemple spécifique, l'alliage comprend sensiblement 70 % de zinc et 30 % restant en nickel et résulte en un système optique interférentiel 40 ayant un contraste C similaire à celui de sensiblement 80 % de zinc et 20 % en nickel sur l'ensemble du spectre visible humain. Comme les figures 5 à 11 le montrent, l'alliage de sensiblement 70 % de zinc et 30 % en nickel présente un indice de réfraction complexe à une longueur d'onde de 550 nm avec n ≈ 2,1 et k ≈ 1,2.

Pour un alliage binaire Ni-Au, la couche 20 d'absorption peut être déposée par galvanoplastie en utilisant un bain d'électrolyte composé d'ammonium nickel sulfate à 10 - 25 % et un pH électrométrique (à 20 °C) de 5,7 à 5,9. La température de dépôt peut être de l'ordre de 65 - 75 °C. De préférence, elle est régulée à 65 °C et la densité de courant de 0,5 à 1,0 A.dm$^{-2}$.

L'alliage binaire obtenu comprend par exemple de 50 à 70 % de nickel en poids total de l'alliage et de 30 à 50 % restant en or. De manière préférée, l'alliage comprend de 60 à 65 % de nickel et de 35 à 40 % d'or. Dans un exemple spécifique, l'alliage comprend sensiblement 62,5 % de nickel et 37,5% d'or, et a une couleur gris noir. Comme les figures 5 à 11 le montrent, l'alliage de sensiblement 62,5 % de nickel et 37,5 % en or présente un indice de réfraction complexe à une longueur d'onde de 550 nm avec n ≈ 2,5 et k = 1,4.

Selon un deuxième exemple, la couche d'absorption peut comprendre de 50 à 97 % de nickel en poids total de l'alliage et de 3 à 50 % restant en zinc. Préférentiellement, la couche d'absorption comprend entre 80 % et 90 % de nickel en poids total de l'alliage et entre 10 % et 20 % restant en zinc. Des alliages de ce type et des méthodes pour les déposer par galvanoplastie sont décrits par exemple dans le document US 4,416,737.

On remarque que, selon différents exemples de l'invention expliqués ci-dessus, le haut contraste C est obtenu pour une partie réelle n de l'indice de réfraction de la couche 20 d'absorption à base de nickel ou à base de zinc à une longueur d'onde de 550 nm avantageusement supérieure ou égale à 1,25, et de préférence supérieure ou égale à 1,5 et encore plus préférentiellement supérieure ou égale à 1,75, et/ou une partie imaginaire k de l'indice de réfraction de la couche 20 d'absorption à une longueur d'onde de 550 nm avantageusement inférieure ou égale à 3,5, et de préférence inférieure ou égale à 2,0, et encore plus préférentiellement inférieure ou égale à 1,5. Ces valeurs diffèrent des valeurs n et k typiques d'autres matériaux métalliques tels que le laiton et l'argent qui ont très souvent une valeur de partie réelle n inférieure à 1,0 et une valeur de partie imaginaire k supérieure à 3.5 à une longueur d'onde de 550 nm.

En outre, il a été observé qu'en ayant une différence ($R_2 - R_1$) entre le coefficient $R_2$ de réflexion à l'interface entre la couche 20 d'absorption et la couche 30 de transmission et celui $R_1$ à l'interface entre de la couche 30 de transmission et l'air entourant le composant horloger 1 sur le spectre visible humain comprise dans une plage d'environ ± 16 %, le contraste C présente typiquement une valeur préférée de haut contraste, c'est-à-dire au moins égale à 0,7. De préférence, la différence ($R_2 - R_1$) entre les coefficients $R_2$ et $R_1$ est comprise entre ± 13 %, et encore plus préférentiellement comprise entre ± 10 % afin d'obtenir un contraste encore plus élevé dans le spectre visible humain.

L'invention n'est pas limitée aux modes de réalisation et variantes présentés et d'autres modes de réalisation et variantes apparaîtront clairement à l'homme du métier. Ainsi, les modes de réalisation et variantes sont combinables entre eux sans sortir du cadre de l'invention. À titre nullement limitatif, il peut être envisagé de faire varier la nature et le nombre de couche(s) 30 de transmission du système optique interférentiel 40 sans sortir du cadre de l'invention.

À titre d'exemple, un système optique interférentiel 40 selon l'invention est illustré à la figure 4. Le système optique interférentiel 40 comprend un empilement de cinq couches 30a, 30b, 30c, 30d, 30e de transmission déposées par une méthode ALD. Les couches 30a, 30c, 30e de transmission peuvent comprendre de l'oxyde d'aluminium ($Al_2O_3$) ou un oxyde stœchiométriquement proche de ce dernier, et peuvent être déposées en utilisant successivement du triméthylaluminium $C_6H_{18}Al_2$ (TMA) et de l'eau déionisée à basse conductivité (par exemple en dessous de 1 μS.cm$^{-1}$) comme des précurseurs dans un réacteur ALD, de préférence à des températures inférieures à 200 °C. Le transfert de précurseurs dans la chambre est assuré par un flux continu de diazote ($N_2$). La durée d'injection pour les précurseurs peut être de 0,1 à 0,5 secondes, ces étapes d'injection étant séparées par des étapes de purge avec le diazote qui durent de 5 à 30 secondes.

Les couches 30b, 30d de transmission peuvent comprendre l'oxyde de titane ($TiO_2$) ou un oxyde stœchiométriquement proche de ce dernier. Elles peuvent être déposées en utilisant du tétrakis(diméthylamino)titane aussi connue comme TDMAT ($Ti(NMe_2)_4$) ou du tétrachlorure de titane ($TiCl_4$) et de l'eau déionisée à basse conductivité comme des précurseurs dans un réacteur ALD à des conditions similaires à celles pour les couches 30a, 30c, 30e.

Pour chaque couche 30a, 30b, 30c, 30d, 30e de transmission, le nombre de cycles de la croissance auto-saturée est bien entendu choisi en fonction de l'épaisseur souhaitée.

Optionnellement, au moins une couche 25 d'adhérence peut être déposée entre la couche 20 d'absorption et le corps 10 du composant 1 pour faciliter le montage du système optique interférentiel 40 sur le corps 10. Chaque couche 25, par exemple à base de nickel pur ou d'or pur, peut ainsi jouer le rôle d'un élément d'accroche pour éviter notamment la délamination entre la couche 20 d'absorption sur le corps 10. Bien entendu, avec ou sans couche 25 d'adhérence, la surface du corps 10 du composant 1 peut être nettoyée ou préparée d'une autre manière avant tout dépôt pour faciliter son accrochage.

**Revendications**

1. Composant horloger (1) formé d'un corps (10) à base d'un matériau à décorer qui est au moins partiellement recouvert d'au moins un système optique interférentiel (40), ce dernier comportant au moins une couche (30) de transmission formée à base d'un oxyde, d'un carbure, d'un sulfure ou d'un nitrure qui est obtenue par une méthode ALD afin d'au moins partiellement transmettre la lumière ambiante pour modifier l'aspect visuel du composant horloger (1), **caractérisé en ce que** le système optique interférentiel (40) comporte en outre une couche (20) d'absorption à base de zinc montée sous la couche (30) de transmission permettant d'améliorer la précision des couleurs obtenues par le système optique interférentiel (40).

2. Composant horloger (1) selon la revendication précédente, dans lequel la couche (20) d'absorption est un alliage comportant au moins 50 % de zinc en poids total de l'alliage.

3. Composant horloger (1) selon la revendication précédente, dans lequel la couche (20) d'absorption est un alliage binaire comportant, outre le zinc, du nickel.

4. Composant horloger (1) selon la revendication précédente, dans lequel la couche (20) d'absorption comprend de 60 à 80 % de zinc en poids total de l'alliage et de 20 à 40 % restant en nickel.

5. Composant horloger (1) selon la revendication précédente, dans lequel la couche (20) d'absorption comprend sensiblement 80 % de zinc en poids total de l'alliage et 20 % restant en nickel.

6. Composant horloger (1) selon la revendication 4, dans lequel la couche (20) d'absorption comprend sensiblement 70 % de zinc en poids total de l'alliage et 30 % restant en nickel.

7. Composant horloger (1) selon l'une quelconque des revendications précédentes, dans lequel la couche (20) d'absorption présente une épaisseur au moins égale à 50 nm, de préférence au moins égale à 100 nm.

8. Composant horloger (1) selon l'une quelconque des revendications précédentes, dans lequel le système optique interférentiel (40) comporte plusieurs couches (30) de transmission empilées l'une sur l'autre par-dessus la couche (20) d'absorption afin de pouvoir sélectionner une couleur précise.

9. Composant horloger (1) selon la revendication précédente, dans lequel au moins une première couche (30) de transmission est empilée sur au moins une deuxième couche (30) de transmission avec respectivement des indices de réfraction différents permettant de faire varier la couleur du composant horloger (1).

10. Composant horloger (1) selon l'une quelconque des revendications précédentes, dans lequel le matériau du corps (10) à décorer est à base de métal, de verre, de silicium, de polymère ou d'une combinaison de ces matières.

11. Procédé de fabrication d'un composant horloger (1) selon l'une quelconque des revendications précédentes, **caractérisé en ce que** le procédé comporte les étapes suivantes :

    - former un corps (10) ;
    - déposer, sur au moins une partie du corps (10), une couche (20) d'absorption à base de zinc ;
    - déposer, par une méthode ALD, au moins une couche (30) de transmission sur la couche (20) d'absorption, chaque couche (30) de transmission étant formée à base d'un oxyde, d'un carbure, d'un sulfure ou d'un nitrure afin de former un système optique interférentiel (40) sur le corps (10).

12. Procédé selon la revendication précédente, dans lequel le corps (10) est formé à base de métal, de verre, de silicium, de polymère ou d'une combinaison de ces matières.

13. Procédé selon la revendication 11 ou 12, comportant, entre l'étape de formation du corps (10) et l'étape de dépôt de la couche (20) d'absorption, une étape de dépôt d'au moins une couche (25) d'adhérence pour faciliter le montage du système optique interférentiel (40) sur le corps (10).

14. Procédé selon l'une quelconque des revendications 11 à 13, dans lequel l'étape de dépôt de la couche (20) d'absorption est réalisée par électrodéposition, par un procédé de dépôt autocatalytique, par un procédé de dépôt physique en phase vapeur ou par un procédé de dépôt chimique en phase vapeur.

15. Procédé selon l'une quelconque des revendications 11 à 14, dans lequel l'étape de dépôt, par la méthode ALD, forme au moins une première couche (30) de transmission empilée sur au moins une deuxième couche (30) de transmission avec respectivement des indices de réfraction différents permettant de faire varier la couleur du composant horloger (1).

TiO$_2$ (nm)

FIG. 1

FIG. 2

FIG. 3

FIG. 4

FIG. 5

FIG. 6

FIG. 7

FIG. 8

FIG. 9

FIG. 10

FIG. 11

Europäisches
Patentamt

European
Patent Office

Office européen
des brevets

# RAPPORT DE RECHERCHE EUROPEENNE

Numéro de la demande

EP 21 16 7741

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| Y | CH 709 669 A1 (POSITIVE COATING SA) 30 novembre 2015 (2015-11-30) | 1,2,7-15 | INV. C23C16/02 |
| A | * alinéas [0011], [0026] - [0027]; revendications 1-2 * | 3-6 | C23C16/455 G04B45/00 G04D3/00 |
| | ----- | | |
| Y | US 2013/029097 A1 (HON FU JIN PREC IND SHENZHEN) 31 janvier 2013 (2013-01-31) | 1,2,7-15 | |
| A | * alinéas [0015] - [0019]; revendications 1,3; figure 1 * | 3-6 | |
| | ----- | | |
| A | US 5 112 693 A (GILLERY FRANK H [US]) 12 mai 1992 (1992-05-12) * le document en entier * | 1 | |
| | ----- | | |

| DOMAINES TECHNIQUES RECHERCHES (IPC) |
|---|
| C23C G04B G04D |

Le présent rapport a été établi pour toutes les revendications

| Lieu de la recherche | Date d'achèvement de la recherche | Examinateur |
|---|---|---|
| La Haye | 14 avril 2021 | Camatchy Toppé, A |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
...........................................................................
& : membre de la même famille, document correspondant

EPO FORM 1503 03.82 (P04C02)

**EP 3 896 192 A1**

**ANNEXE AU RAPPORT DE RECHERCHE EUROPEENNE
RELATIF A LA DEMANDE DE BREVET EUROPEEN NO.**

EP 21 16 7741

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

14-04-2021

| Document brevet cité au rapport de recherche | | Date de publication | Membre(s) de la famille de brevet(s) | | Date de publication |
|---|---|---|---|---|---|
| CH 709669 | A1 | 30-11-2015 | AUCUN | | |
| US 2013029097 | A1 | 31-01-2013 | CN | 102899610 A | 30-01-2013 |
| | | | TW | 201305357 A | 01-02-2013 |
| | | | US | 2013029097 A1 | 31-01-2013 |
| US 5112693 | A | 12-05-1992 | AT | 181310 T | 15-07-1999 |
| | | | AU | 605047 B2 | 03-01-1991 |
| | | | CA | 1337057 C | 19-09-1995 |
| | | | CN | 1041579 A | 25-04-1990 |
| | | | DE | 68929017 T2 | 05-01-2000 |
| | | | DK | 484089 A | 04-04-1990 |
| | | | EP | 0363747 A1 | 18-04-1990 |
| | | | FI | 894511 A | 04-04-1990 |
| | | | GR | 3031228 T3 | 31-12-1999 |
| | | | JP | 2604474 B2 | 30-04-1997 |
| | | | JP | H02145458 A | 04-06-1990 |
| | | | KR | 900006250 A | 07-05-1990 |
| | | | NO | 174845 B | 11-04-1994 |
| | | | NZ | 230494 A | 28-04-1992 |
| | | | US | 5112693 A | 12-05-1992 |
| | | | ZA | 896264 B | 24-04-1991 |

EPO FORM P0460

Pour tout renseignement concernant cette annexe : voir Journal Officiel de l'Office européen des brevets, No.12/82

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 2013029097 A
- CH 711122
- US 4416737 A